# EUROPEAN PATENT APPLICATION

(11) **EP 4 539 096 A1**
(43) Date of publication of application: **16.04.2025**
(21) Application number: 23819789.1
(22) Date of filing: 05.06.2023
(51) Int. Cl.: H01L 21/02, B23K 20/00

(54) **JOINING DEVICE**

(30) Priority: 08.06.2022 JP 2022092779
(71) Applicant: Tazmo Co., Ltd., Okayama-shi, Okayama 701-1221 (JP)
(72) Inventor: IKAGAWA, Yoshinori, Okayama-shi, Okayama 701-1221 (JP)
(74) Representative: Knöner, Gregor
(86) International application number: PCT/JP2023/020743
(87) International publication number: WO 2023/238809

(57) **Abstract**

A joining apparatus joins a first joining target and a second joining target to each other using laser light, and comprises a first stage, a pressurizing mechanism, a second stage, and a laser light source. The first stage is transmissive to the laser light and is located on the side of a back surface of the first joining target. The pressurizing mechanism applies a pressure to the back surface of the first joining target. The second stage includes a pressure-receiving surface for receiving the pressure from the pressurizing mechanism at a back surface of the second joining target. The laser light source applies the laser light through the first stage to a place of joining between the first joining target and the second joining target. The pressurizing mechanism includes a pressure transmission medium composed of gas or liquid and applies the pressure to the back surface of the first joining target with the transmission medium in contact with this back surface.

## Description

### Technical Field

The present invention relates to a joining technique using laser light.

### Background Art

One of existing techniques of manufacturing semiconductor devices (such as MEMSs) is a technique of joining two wafers to each other utilizing eutectic reaction between two types of metals. According to this technique, a metal layer containing one of two types of metals (aluminum (Al) and germanium (Ge), for example) to generate eutectic reaction as a major constituent and a metal layer containing the other metal as a major constituent are formed on respective joint surfaces of two wafers. Eutectic reaction is generated at a place of contact between the metal layers, thereby joining the two wafers to each other. As an example, this technique is used for sealing a sensor (such as a gyroscope sensor or a biosensor) or a waveguide in a device.

To generate eutectic reaction according to such a joining technique, it is required to bring the two metal layers into contact with each other with no gap therebetween and it is also required to heat the place of contact between the metal layers to a temperature at which eutectic reaction is generated. The place of contact between the two metal layers has conventionally been formed by interposing the two wafers under pressure to bring the two metal layers into contact with each other and has been heated by heating the two wafers entirely together with a sensor, etc. to be sealed (see Patent Literature 1, for example).

### Citation List

### Patent Literatures

Patent literature 1: Japanese published unexamined patent application No. 11-220141 (1999)
Patent Literature 2: Chinese published utility model registration No. 210223961

### Summary of Invention

### Technical Problem

According to the above-described conventional joining technique, however, heating even a sensor to be sealed causes a risk of damage of the sensor with heat. Hence, a sensor that can be sealed in a device is limited to a sensor having high heat resistance. Furthermore, temperature increase at a joining place (temperature increase to a temperature at which eutectic reaction is generated) takes long time. Additionally, as it is required to relieve thermal stress on the wafers gradually after the joining, temperature decrease also takes long time. Hence, a problem arises in that long time is required for performing a joining process once.

Another problem also arises in that, if the above-described two types of metals have different values of coefficients of linear expansion, a place of joining between the two metal layers is exposed to a risk of distortion during temperature increase (during heating) or during temperature decrease (during cooling). Hence, in selecting the two types of metals according to the above-described conventional joining technique, it is required to select metals having approximate values of coefficients of linear expansion in order to reduce the occurrence of such distortion. This imposes severe limitation on a degree of freedom in the selection.

In response to this, according to a technique recently suggested, heat is applied locally to a place of contact between two metal layers as a target using laser light (see Patent Literature 2). More specifically, two wafers are interposed under pressure between a quartz plate transmissive to laser light and a different member (such as a chuck), and in this state, laser light is applied through the quartz plate to the place of contact between the two metal layers.

According to this joining technique using laser light, as the place of contact between the two metal layers is heated locally, thermal influence on a sensor is reduced. As a result, it becomes possible to seal a sensor with low heat resistance in a device. Furthermore, as a place of joining between the two metal layers can be heated intensively with laser light, a temperature at the joining place can be increased rapidly to a temperature at which eutectic reaction is generated. As a result, it becomes possible to shorten time required for a joining process. This joining technique using laser light is effective not only in joining utilizing eutectic reaction (eutectic bonding) but also in various joining types requiring local heating such as solder joining and weld joining.

If the above-described two types of metals have different values of coefficients of linear expansion and if distortion occurs during temperature increase (during heating) or during temperature decrease (during cooling), the occurrence of the distortion is limited only to a local area to be applied with laser light. Thus, the amount of distortion is considerably small, so that influence of the distortion on the place of joining between the two metal layers is considerably small. Thus, in selecting the two types of metals, it becomes possible to select metals having different values of coefficients of linear expansion to increase a degree of freedom in the selection.

On the other hand, according to the joining technique using laser light, the wafer as a joining target is stuck to the quartz plate by being interposed under pressure and heated as described above, making it difficult to separate the wafer from the quartz plate. Such sticking of the wafer to the quartz plate causes a risk of damage of the wafer during separation from the quartz plate.

The present invention is intended to prevent damage of a joining target in a joining technique using laser light.

### Solution to Problem

A joining apparatus according to the present invention joins a first joining target and a second joining target to each other using laser light, and comprises a first stage, a pressurizing mechanism, a second stage, and a laser light source. The first stage is transmissive to the laser light and is located on the side of a back surface of the first joining target. The pressurizing mechanism applies a pressure to the back surface of the first joining target. The second stage includes a pressure-receiving surface for receiving the pressure from the pressurizing mechanism at a back surface of the second joining target. The laser light source applies the laser light through the first stage to a place of joining between the first joining target and the second joining target. The pressurizing mechanism includes a pressure transmission medium composed of gas or liquid and applies the pressure to the back surface of the first joining target with the transmission medium in contact with this back surface.

The above-described joining apparatus allows a pressure to be applied directly to the back surface of the first joining target using the pressure transmission medium (gas or liquid). As a result, the back surface of the first joining target can be applied with the pressure in a state of not contacting the first stage. Thus, even using application of laser light, the occurrence of sticking of the first joining target to the first stage is still avoided.

### Advantageous Effects of Invention

According to the present invention, it is possible to prevent damage of a joining target in a joining technique using laser light.

### Brief Description of Drawings

FIG. 1 is a conceptual view illustrating two joining targets to be joined to each other by a joining apparatus.
FIG. 2A is a sectional view showing examples of pattern shapes of a first metal layer and a second metal layer, and FIG. 2B is a plan view showing these examples.
FIG. 3A and FIG. 3B are conceptual views showing a joining apparatus according to a first embodiment. FIG. 3A shows a state with a second stage in a moved-up position. FIG. 3B shows a state with the second stage in a moved-down position.
FIG. 4 is a conceptual view showing a joining apparatus according to a second embodiment.

### Description of Embodiments

### [1] Joining Target

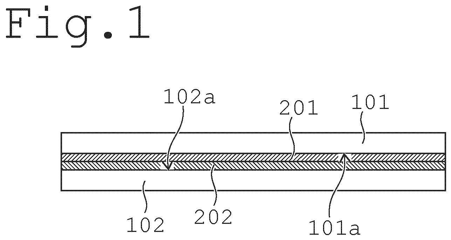

FIG. 1 is a conceptual view illustrating two joining targets 101 and 102 to be joined to each other by a joining apparatus described later. The joining targets 101 and 102 are semiconductor wafers, for example, and have respective joint surfaces 101a and 102a where a first metal layer 201 and a second metal layer 202 are formed respectively. Here, the first metal layer 201 contains one of two types of metals to generate eutectic reaction as a major constituent, and the second metal layer 202 contains the other metal as a major constituent. Examples of a combination of the two types of metals include a combination of aluminum (Al) and germanium (Ge), a combination of copper (Cu) and tin (Sn), a combination of silver (Ag) and tin (Sn), and a combination of indium (In) and tin (Sn). While these layers are not particularly limited, they are formed by vacuum film deposition (including sputtering and vapor deposition) or application of the metals to the joint surfaces 101a and 102a.

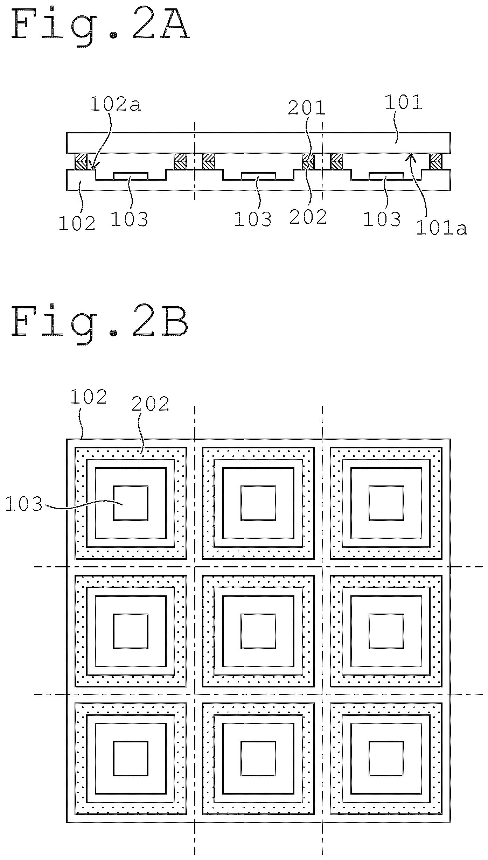

FIG. 1 schematically shows a case where the first metal layer 201 is formed over the entire area of the joint surface 101a and the second metal layer 202 is formed over the entire area of the joint surface 102a. In an actual process of manufacturing a semiconductor device (such as a MEMS), however, the first metal layer 201 and the second metal layer 202 are patterned into various shapes in conformity with the shape or purpose of use of the device, for example. FIGS. 2A and 2B are a sectional view and a plan view respectively showing examples of pattern shapes of the first metal layer 201 and the second metal layer 202. Of the first metal layer 201 and the second metal layer 202, FIG. 2B shows only the second metal layer 202 in a plan view. In this example, in order to allow one sensor 103 to be sealed in each device, the first metal layer 201 and the second metal layer 202 are each formed into a quadrangular frame-like shape surrounding one sensor 103. The pattern shape of each of the first metal layer 201 and the second metal layer 202 is not limited to a quadrangular frame-like shape but is appropriately changeable in conformity with the shape or purpose of use of a device, for example.

The joining apparatus described below connects the first metal layer 201 and the second metal layer 202 to each other by utilizing eutectic reaction generated by heating a place of contact between these metal layers (a place of joining between the joining target 101 and the joining target 102) with laser light (namely, by utilizing eutectic bonding with laser light), thereby joining the respective joint surfaces 101a and 102a of the two joining targets 101 and 102 to each other.

### [2] Joining Apparatus

### [2-1] First embodiment

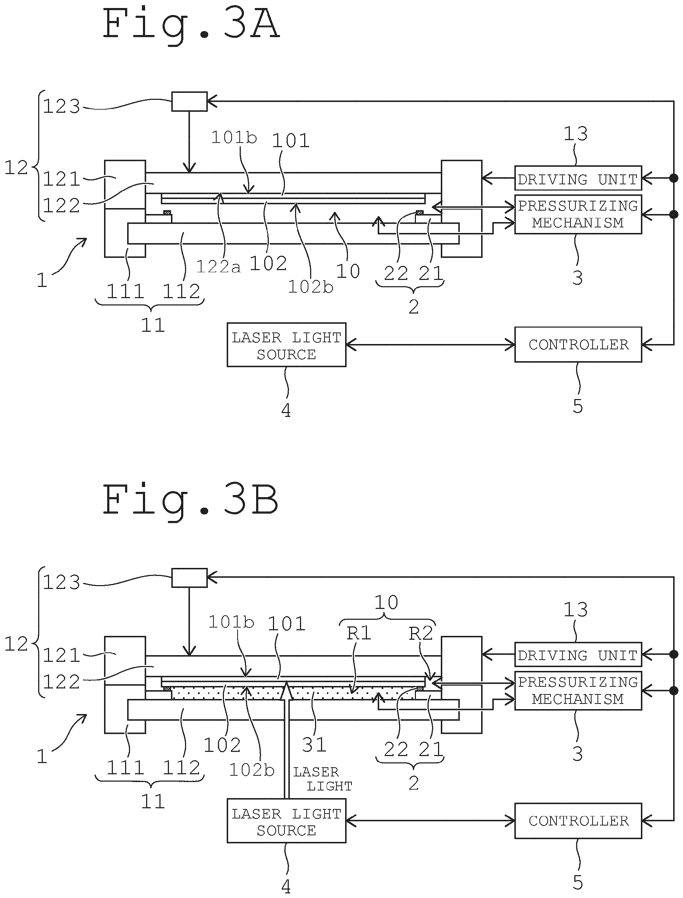

FIG. 3A and FIG. 3B are conceptual views showing a joining apparatus according to a first embodiment. As shown in these drawings, the joining apparatus of the present embodiment includes a chamber mechanism 1, a sealing mechanism 2, a pressurizing mechanism 3, a laser light source 4, and a controller 5. The configuration of each part will be described below in detail.

### <Chamber Mechanism 1>

The chamber mechanism 1 includes a first chamber structure unit 11, a second chamber structure unit 12, and a driving unit 13 that drives at least one of these structure units.

The first chamber structure unit 11 and the second chamber structure unit 12 form enclosed space (hereinafter called a "chamber 10") for implementation of a joining process. The first chamber structure unit 11 and the second chamber structure unit 12 are configured to realize formation and opening of the chamber 10 selectively by moving closer to and away from each other in a vertical direction. Particulars thereof will be described below.

The first chamber structure unit 11 is composed of a first circular cylindrical part 111, and a first stage 112 supported inside the first circular cylindrical part 111 with no gap therebetween. The first circular cylindrical part 111 is arranged with a center axis thereof extending in a direction conforming to the vertical direction. The first stage 112 is supported horizontally by the first circular cylindrical part 111. Here, the first stage 112 is transmissive to laser light and is made of quartz, for example.

The second chamber structure unit 12 is composed of a second circular cylindrical part 121 arranged over the first circular cylindrical part 111 and coaxially with the first circular cylindrical part 111, a second stage 122 supported inside the second circular cylindrical part 121 with no gap therebetween in such a manner as to be movable up and down, and a driving unit 123 for moving the second stage 122 up and down. An upper end of the first circular cylindrical part 111 and a lower end of the second circular cylindrical part 121 contact each other with no gap therebetween, thereby forming the chamber 10 between the first stage 112 and the second stage 122. FIG. 3A shows a state with the second stage 122 in a moved-down position. FIG. 3B shows a state with the second stage 122 in a moved-down position.

As described above, the chamber mechanism 1 is capable of forming the chamber 10 between the first stage 112 and the second stage 122.

The second stage 122 has the function of chucking a joining target. More specifically, the second stage 122 has a suction surface 122a for suction of a back surface 101b of the joining target 101 or a back surface 102b of the joining target 102. As an example, the suction surface 122a is composed of a planar surface with a suction groove formed over the entire area of the suction surface 122a and capable of reducing its internal pressure through vacuum suction, for example.

In the present embodiment, the two joining targets 101 and 102, in a state of being provisionally joined to each other, are chucked by the second stage 122 by sucking the back surface of one of these joining targets to the suction surface 122a. In the following description of the present embodiment, of the joining targets 101 and 102 chucked by the second stage 122, a joining target farther from the second stage 122 will be called a "first joining target," and a joining target closer to the second stage 122 will be called a "second joining target." In the illustrations in FIGS. 3A and 3B, the joining targets 101 and 102 are chucked by the second stage 122 with the joining target 102 placed under the joining target 101, so that the joining target 102 corresponds to the "first joining target" and the joining target 101 corresponds to the "second joining target." Thus, the first stage 112 is located on the side of the back surface of the first joining target, and the second stage 122 is located on the side of the back surface of the second joining target.

When the pressurizing mechanism 3 described later applies a pressure to the back surface of the first joining target (in the illustrations in FIGS. 3A and 3B, the back surface 102b of the joining target 102), the second stage 122 receives the applied pressure on the side of the back surface of the second joining target (in the illustrations in FIGS. 3A and 3B, the back surface 101b of the joining target 101). More specifically, the suction surface 122a of the second stage 122 further functions as a pressure-receiving surface for receiving a pressure from the pressurizing mechanism 3.

The driving unit 13 moves at least one of the first chamber structure unit 11 and the second chamber structure unit 12 in the vertical direction, thereby causing these structure units to move closer to and farther from each other relatively.

### <Sealing Mechanism 2>

The sealing mechanism 2 partitions space in the chamber 10 into a plurality of regions and provides sealing between the regions next to each other (see FIG. 3B). More specifically, the sealing mechanism 2 partitions the space in the chamber 10 into a first region R1 facing the back surface 102b of the joining target 102 (the back surface of the first joining target) and a second region R2 next to the first region R1, and provides sealing between these regions. Particulars thereof will be described below.

The sealing mechanism 2 is composed of a flange part 21 and a sealing part 22. The flange part 21 is an annular part protruding from a position along an inner surface of the first circular cylindrical part 111 and higher than the first stage 112 (namely, a position close to the second circular cylindrical part 121) toward the center axis of the first circular cylindrical part 111. When viewed from vertically below, the flange part 21 extends to a position overlapping peripheral portions of the joining targets 101 and 102 chucked by the second stage 122. The sealing part 22 is a sealing member (such as an O-ring) having an annular shape, and is provided on an upper surface of a tip of the flange part 21 in a facing relationship over the entire perimeter with the peripheral portions of the joining targets 101 and 102 chucked by the second stage 122.

With this sealing mechanism 2, when the second stage 122 is moved down, the sealing part 22 comes into abutting contact from below over the entire perimeter on the peripheral portions of the joining targets 101 and 102 chucked by the second stage 122. By doing so, the peripheral portions of the joining targets 101 and 102 are interposed over the entire perimeter between the suction surface 122a (pressure-receiving surface) of the second stage 122 and the sealing part 22. As a result, with space between the back surface 102b of the joining target 102 (the back surface of the first joining target) and the first stage 112 defined as the first region R1, sealing is provided between the first region R1 and the second region R2 by the sealing mechanism 2.

In the present embodiment, the width of the first region R1 in the vertical direction (namely, a width between the back surface 102b of the joining target 102 (the back surface of the first joining target) and the first stage 112) is set to a size greater than the wavelength of laser light to be used for joining, preferably, set to a size about 10 times the wavelength or more. The reason for such setting will be described later.

### <Pressurizing mechanism 3>

The pressurizing mechanism 3 applies a pressure to the back surface of the first joining target (in the illustrations in FIGS. 3A and 3B, the back surface 102b of the joining target 102). More specifically, the pressurizing mechanism 3 has a pressure transmission medium 31 composed of gas or liquid. With the transmission medium 31 in contact with the back surface of the first joining target, the pressurizing mechanism 3 applies a pressure to this back surface. Particulars thereof will be described below.

The pressurizing mechanism 3 is capable of adjusting internal pressures in regions individually resulting from the partitioning of the chamber 10 by the sealing mechanism 2, capable of reducing a pressure in each region, and further capable of applying a pressure to the first region R1 using the transmission medium 31. The pressure is applied to the first region R1 by supplying the transmission medium 31 (gas or liquid) to the first region R1 using a compression pump, for example. The pressurizing mechanism 3 makes an internal pressure in the first region R1 higher than an internal pressure in the second region R2, thereby applying a pressure to the back surface of the first joining target using a difference between the internal pressures.

### <Laser Light Source 4>

The laser light source 4 is to emit laser light, and is arranged below the first stage 112 transmissive to laser light. The laser light source 4 is capable of performing a scan with laser light within a horizontal plane along the pattern shapes of the first metal layer 201 and the second metal layer 202 while applying the laser light through the first stage 112 toward the joining targets 101 and 102 held over the first stage 112 across the first region R1. The laser light source 4 is further capable of focusing the laser light on a place of contact between the first metal layer 201 and the second metal layer 202 (a place of joining between the joining target 101 and the joining target 102).

### <Controller 5>

The controller 5 is composed of a processor such as a CPU or a microcomputer, and controls various operation units (including the chamber mechanism 1, the pressurizing mechanism 3, and the laser light source 4) of the joining apparatus. Particulars thereof will be described below.

During implementation of the joining process, the controller 5 first causes the first chamber structure unit 11 and the second chamber structure unit 12 to move farther from each other to open the chamber 10 and in this state, chucks the joining targets 101 and 102 on the suction surface 122a of the second stage 122 while the joining targets 101 and 102 are in a state of being provisionally joined to each other. Then, the controller 5 causes the first chamber structure unit 11 and the second chamber structure unit 12 to move closer to each other to unite these structure units, thereby forming the chamber 10 (see FIG. 3A). At this time, the controller 5 moves up the second stage 122 so as to separate the joining targets 101 and 102 from the sealing part 22 (specifically, so as to release sealing between the first region R1 and the second region R2).

Next, the controller 5 controls the pressurizing mechanism 3 to reduce an internal pressure in the chamber 10 entirely until a vacuum state is formed in the chamber 10. At this time, as the peripheral portions of the joining target 101 and the joining target 102 are opened without being interposed between the suction surface 122a (pressure-receiving surface) of the second stage 122 and the sealing part 22 (namely, as these peripheral portions are released from sealing), flow of gas to pass through between the joining targets 101 and 102 is not interrupted at the peripheral portions. Thus, if a gap is present between the joining target 101 and the joining target 102, it is possible to reduce an internal pressure in the gap. On the other hand, if the peripheral portions of the joining target 101 and the joining target 102 are interposed between the suction surface 122a (pressure-receiving surface) of the second stage 122 and the sealing part 22 (namely, if sealing is provided between these peripheral portions), flow of gas is interrupted at the peripheral portions. Thus, even if a gap is present between the joining target 101 and the joining target 102, it becomes difficult to reduce an internal pressure in the gap.

Then, the controller 5 moves down the second stage 122, thereby forming abutting contact of the sealing part 22 from below over the entire perimeter on the peripheral portions of the joining targets 101 and 102 chucked by the second stage 122 (see FIG. 3B). By doing so, the peripheral portions of the joining targets 101 and 102 are interposed over the entire perimeter between the suction surface 122a (pressure-receiving surface) of the second stage 122 and the sealing part 22. As a result, the first region R1 and the second region R2 are formed and sealing is provided therebetween.

In this state, the controller 5 controls the pressurizing mechanism 3 to increase an internal pressure in the first region R1 while maintaining a vacuum state in the second region R2. This makes the internal pressure in the first region R1 higher than an internal pressure in the second region R2 and a pressure responsive to a difference between the internal pressures is applied to the back surface 102b of the joining target 102 (the back surface of the first joining target). At this time, it is possible to change the pressure to be applied to the back surface 102b of the joining target 102 to an intended value by changing the internal pressure in the first region R1. As long as the internal pressure in the first region R1 has a higher value than the internal pressure in the second region R2, it may be set to a value lower than atmospheric pressure, to a value substantially equal to atmospheric pressure, or to a value higher than atmospheric pressure.

In a state after the pressure is applied by the pressurizing mechanism 3 to the back surface 102b of the joining target 102 (the back surface of the first joining target), the controller 5 controls the laser light source 4 while maintaining this state, thereby applying laser light through the first stage 112 to a place of contact between the first metal layer 201 and the second metal layer 202 (a place of joining between the joining target 101 and the joining target 102). The controller 5 performs a scan with the laser light within a horizontal plane along the pattern shapes of the first metal layer 201 and the second metal layer 202. As a result, it is possible to connect the first metal layer 201 and the second metal layer 202 to each other by eutectic bonding over the entire areas of the joining targets 101 and 102. In this way, the respective joint surfaces 101a and 102a of the two joining targets 101 and 102 are joined to each other.

In the above-described joining apparatus, the first region R1 is a region to be filled with the pressure transmission medium 31 (gas or liquid) and the back surface 102b of the joining target 102 (the back surface of the first joining target) is exposed in the first region R1. Thus, the back surface 102b of the joining target 102 (the back surface of the first joining target) directly contacts the pressure transmission medium 31 (gas or liquid), so that the back surface 102b is pressed directly with the transmission medium 31 during pressure application. In this way, the above-described joining apparatus allows a pressure to be applied directly to the back surface 102b of the joining target 102 (the back surface of the first joining target) using the pressure transmission medium 31 (gas or liquid). As a result, the back surface 102b of the joining target 102 (the back surface of the first joining target) can be applied with the pressure in a state of not contacting the first stage 112. Thus, even after application of laser light, the occurrence of sticking of the joining target 102 (first joining target) to the first stage 112 is still avoided. Thus, damage of the joining target is prevented in a joining technique using laser light.

By applying a pressure directly using the pressure transmission medium 31 (gas or liquid), the pressure can always be applied uniformly to the back surface 102b of the joining target 102 (the back surface of the first joining target). Thus, even if the applied pressure is low, it is still possible to deform the joining target 102 (first joining target) so as to eliminate a gap between the first metal layer 201 and the second metal layer 202 and to maintain the resultant state. As a result, even with the relatively low pressure, it is still possible to bring the first metal layer 201 and the second metal layer 202 into contact with each other extensively while forming no gap therebetween. By reducing a pressure required for the joining in this way, strength required for the first stage 112 is also reduced correspondingly (strength providing resistance to pressure application during joining). As a result, it becomes possible to reduce the first stage 112 in a relatively small thickness.

If liquid is used as the transmission medium 31 and the first region R1 is filled with the liquid, the liquid can be used for removing heat generated during the joining process (application of laser light) or for reducing energy loss of laser light by reducing a difference in refractive index between the first stage 112 and the first region R1.

As described above, in the present embodiment, the width of the first region R1 in the vertical direction (namely, a width of space defined between the back surface 102b of the joining target 102 (the back surface of the first joining target) and the first stage 112 and in which the transmission medium 31 is interposed) is set to a size greater than the wavelength of laser light to be used for joining. Thus, even if a foreign matter is present between the back surface 102b of the joining target 102 (the back surface of the first joining target) and the first stage 112 and the foreign matter has a size substantially equal to or less than the wavelength of the laser light, a gap corresponding to the width of the first region R1 in the vertical direction (namely, a gap having a width greater than the wavelength of the laser light to be used for joining) is still ensured between the back surface 102b of the joining target 102 and the first stage 112. As a result, the occurrence of an interference fringe of the laser light or deformation of the joining target 102 (first joining target) due to the foreign matter is prevented during application of the laser light.

The above-described joining apparatus may further include an alignment mechanism (not shown in the drawings) that adjusts the positions of the joining targets 101 and 102 chucked by the second stage 122. As an example, the alignment mechanism can be used for adjusting the position of the second stage 122 by adjusting the position of at least one of the first chamber structure unit 11 and the second chamber structure unit 12 in a horizontal plane.

In the above-described joining apparatus, the positions of the first stage 112 and the second stage 122 relative to each other may be changed to relative positions switched from each other vertically, as appropriate. In response to this, the positions of the other units (including the pressurizing mechanism 3 and the laser light source 4) may be changed, as appropriate.

The configuration of applying a pressure to the back surface 102b of the joining target 102 (the back surface of the first joining target) using a pressure difference is applicable not only to the case of heating a place of joining between the joining target 101 and the joining target 102 with laser light but also to the case of heating the joining place using different heating means (for example, the case of heating the joining targets 101 and 102 entirely). Thus, the foregoing configuration using a pressure difference can be extracted as the invention from the present embodiment.

In the above-described joining apparatus, the pressurizing mechanism 3 is not limited to the mechanism that applies a pressure to the back surface of the first joining target with gas or liquid (pressure transmission medium 31) in contact with this back surface but may be changed to a mechanism that applies a pressure to the back surface of the first joining target using a diaphragm transmissive to laser light, as appropriate.

The above-described joining apparatus is applicable not only to complete joining of joining a place of contact entirely between the first metal layer 201 and the second metal layer 202 with laser light but also to provisional joining of joining only some parts of the place of contact between the first metal layer 201 and the second metal layer 202 with laser light. Here, the provisional joining is a joining process performed to maintain the positions of the joining targets 101 and 102 relative to each other adjusted by the alignment mechanism (not shown in the drawings) so as not to cause disturbance of the relative positions due to vibration occurring during transport, for example.

### [2-2] Second Embodiment

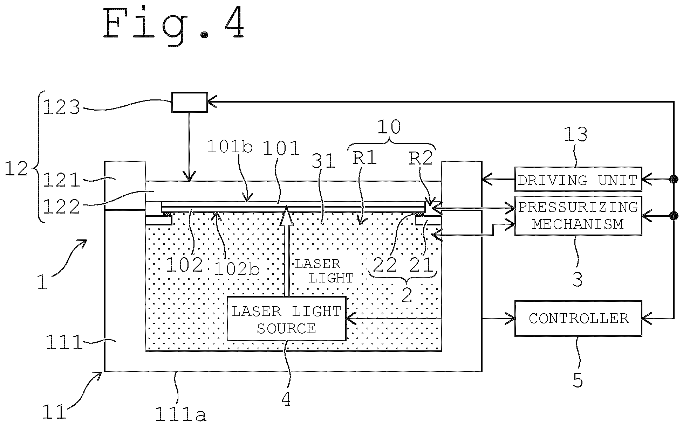

FIG. 4 is a conceptual view showing a joining apparatus according to a second embodiment. The joining apparatus of the present embodiment is provided by changing the configurations of the chamber mechanism 1 and the laser light source 4 as follows in the joining apparatus of the first embodiment.

At the chamber mechanism 1, the first chamber structure unit 11 does not include the first stage 112. Instead of this, the first circular cylindrical part 111 is formed into a cylindrical shape with a closed bottom. In the present embodiment, space between the back surface 102b of the joining target 102 (the back surface of the first joining target) and a bottom 111a of the first circular cylindrical part 111 is used as the first region R1.

The laser light source 4 is provided in the first region R1. Thus, in the present embodiment, laser light is applicable to a place of joining between the joining targets 101 and 102 directly without intervention of a stage such as a quartz plate. In this way, it is possible to reduce energy loss in the present embodiment.

The above explanations of the embodiments are nothing more than illustrative in any respect, nor should be thought of as restrictive. The scope of the present invention is indicated by claims rather than the above embodiments. Furthermore, it is intended that all changes that are equivalent to a claim in the sense and realm of the doctrine of equivalence be included within the scope of the present invention.

For example, the above-described joining apparatuses are applicable not only to joining utilizing eutectic reaction (eutectic bonding) but also to various joining types requiring local heating including solder joining and weld joining, and further including diffusion joining.

A subject to be extracted as an invention from the above-described embodiments includes not only the above-described joining apparatuses but may also include some of the structures of the joining apparatuses, a joining method implemented by using these joining apparatuses, and others.

### Reference Signs List

1 Chamber mechanism
2 Sealing mechanism
3 Pressurizing mechanism
4 Laser light source
5 Controller
10 Chamber
11 First chamber structure unit
12 Second chamber structure unit
13 Driving unit
21 Flange part
22 Sealing part
31 Transmission medium
R1 First region
R2 Second region
101, 102 Joining target
101a, 102a Joint surface
101b, 102b Back surface
103 Sensor
111 First circular cylindrical part
111a Bottom
112 First stage
121 Second circular cylindrical part
122 Second stage
122a Suction surface (pressure-receiving surface)
123 Driving unit
201 First metal layer
202 Second metal layer

## Claims

1. A joining apparatus that joins a first joining target and a second joining target to each other using laser light, comprising:
a first stage transmissive to the laser light and located on the side of a back surface of the first joining target;
a pressurizing mechanism that applies a pressure to the back surface of the first joining target;
a second stage including a pressure-receiving surface for receiving the pressure from the pressurizing mechanism at a back surface of the second joining target; and
a laser light source that applies the laser light through the first stage to a place of joining between the first joining target and the second joining target, wherein
the pressurizing mechanism includes a pressure transmission medium composed of gas or liquid and applies the pressure to the back surface of the first joining target with the transmission medium in contact with the back surface of the first joining target.

2. The joining apparatus according to claim 1, further comprising:
a chamber mechanism capable of forming a chamber between the first stage and the second stage; and
a sealing mechanism that partitions space in the chamber into a plurality of regions and provides sealing between the regions next to each other, wherein
the plurality of regions includes a first region facing the back surface of the first joining target, and a second region next to the first region,
the sealing mechanism includes a sealing part capable of providing sealing between the first region and the second region, with space between the back surface of the first joining target and the first stage defined as the first region, the sealing mechanism provides sealing between the first region and the second region by interposing peripheral portions of the first joining target and the second joining target between the sealing part and the pressure-receiving surface of the second stage, and
the pressurizing mechanism is capable of adjusting internal pressures in the regions individually, and makes an internal pressure in the first region higher than an internal pressure in the second region, thereby applying the pressure to the back surface of the first joining target using a difference between the internal pressures.

3. The joining apparatus according to claim 2, further comprising:
a controller, wherein
the controller reduces an internal pressure in the chamber before providing sealing between the first region and the second region,
the controller thereafter controls the sealing mechanism to provide sealing between the first region and the second region, and
the controller thereafter controls the pressurizing mechanism to increase the internal pressure in the first region.
